**Europäisches Patentamt**

**European Patent Office**

**Office européen des brevets**

(19)

(11) Veröffentlichungsnummer: **0 075 719**
**B1**

# (12) EUROPÄISCHE PATENTSCHRIFT

(45) Veröffentlichungstag der Patentschrift:
**10.12.86**

(21) Anmeldenummer: **82107549.6**

(22) Anmeldetag: **18.08.82**

(51) Int. Cl.⁴: **H 01 L 29/743, H 01 L 29/08**

(54) **Thyristor mit steuerbaren Emitter-Kurzschlüssen und Zündverstärkung.**

(30) Priorität: **29.09.81 DE 3138762**

(43) Veröffentlichungstag der Anmeldung:
**06.04.83 Patentblatt 83/14**

(45) Bekanntmachung des Hinweises auf die Patenterteilung:
**10.12.86 Patentblatt 86/50**

(84) Benannte Vertragsstaaten:
**CH FR GB IT LI NL SE**

(56) Entgegenhaltungen:
**EP - A - 0 028 797**
**EP - A - 0 028 798**
**DE - A - 2 625 917**
**DE - A - 2 945 366**

(73) Patentinhaber: **Siemens Aktiengesellschaft Berlin und München, Wittelsbacherplatz 2, D-8000 München 2 (DE)**

(72) Erfinder: **Stoisiek, Michael, Dr. Dipl.-Phys., Robert-Koch-Strasse 24, D-8012 Ottobrunn (DE)**

## Beschreibung

Die Erfindung bezieht sich auf einen Thyristor nach dem Oberbegriff des Anspruchs 1.

Ein Thyristor dieser Art wird in der älteren deutschen Patentanmeldung DE-A-3 118 354 beschrieben. Zum Zünden eines solchen Thyristors ist neben einem Zündstromimpuls auch ein Steuerspannungsimpuls für die MIS-Strukturen erforderlich, der mit dem ersteren zeitlich zusammenfällt.

Der Erfindung liegt die Aufgabe zugrunde, einen Thyristor der eingangs genannten Art anzugeben, bei dem die Zündung einschliesslich der während des Zündvorgangs erforderlichen Steuerung der Emitter-Kurzschlüsse in einfacher Weise von einem angelegten Zündstromimpuls abgeleitet wird. Das wird erfindungsgemäss durch eine Ausbildung des Thyristors nach dem kennzeichnenden Teil des Anspruchs 1 erreicht.

Der mit der Erfindung erzielbare Vorteil liegt insbesondere darin, dass die während des blockierenden Zustandes in den Gate-Kapazitäten der MIS-Strukturen gespeicherte elektrische Energie mit zur Zündung herangezogen wird und man daher mit einer relativ geringen Steuerleistung zum Auslösen des Zündvorganges auskommt.

Die Ansprüche 2 bis 6 betreffen vorteilhafte Ausgestaltungen und Weiterbildungen der Erfindung.

Die Erfindung wird nachfolgend anhand der Zeichnung näher erläutert. Dabei zeigt:

Fig. 1 ein bevorzugtes Ausführungsbeispiel des Thyristors nach der Erfindung, und

Fig. 2 ein Ersatzschaltbild der Anordnung nach Fig. 1.

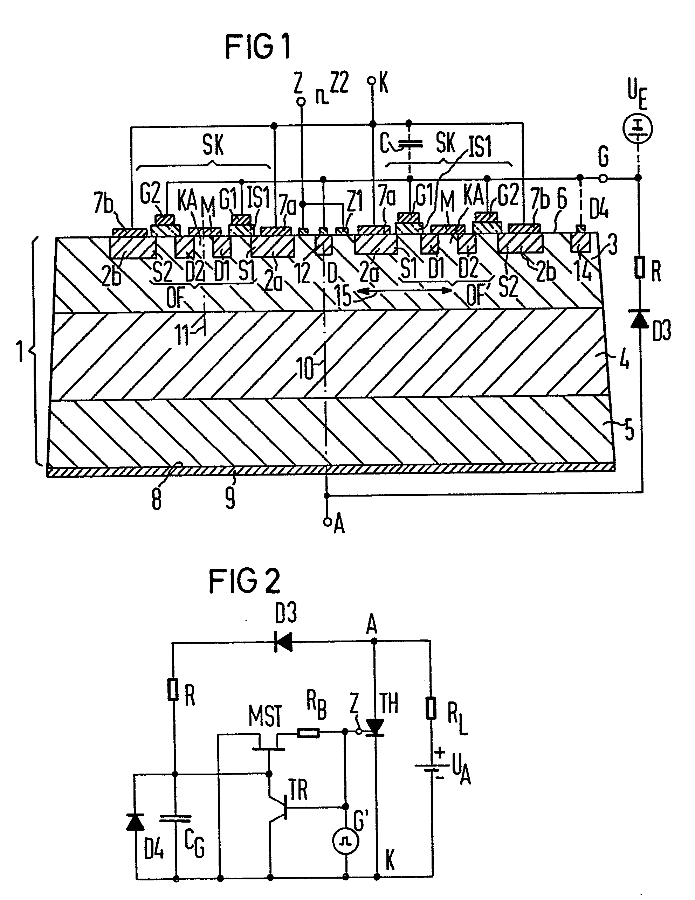

In Fig. 1 ist ein nach der Erfindung ausgebildeter Thyristor dargestellt. Er weist einen Körper 1 aus monokristallinem Halbleitermaterial, z.B. Silizium, auf, der n-leitende Schichten 2a, 2b und 4 und p-leitende Schichten 3 und 5 enthält. Die aus zwei Teilen 2a und 2b bestehende Schicht wird auch als n-Emitter bezeichnet, die Schicht 3 als p-Basis, die Schicht 4 als n-Basis und die Schicht 5 als p-Emitter. Die Teile 2a und 2b des n-Emitters sind an der Grenzfläche 6 des Halbleiterkörpers 1 mit Belegungen 7a und 7b aus elektrisch leitendem Material, z.B. Aluminium, versehen, die zusammen die Kathode des Thyristors bilden. Sie sind mit einem Anschluss K verbunden. Der p-Emitter 5 wird in der gegenüberliegenden Grenzfläche 8 des Halbleiterkörpers von einer Anode 9 aus elektrisch leitendem Material, z.B. Aluminium, kontaktiert. Die Anode 8 ist mit einem Anschluss A versehen.

Der n-Emitter 2a, 2b ist in Fig. 1 mit steuerbaren Emitter-Kurzschlüssen SK versehen, die jeweils aus einem MIS-Feldeffekttransistor, z.B. S1, D1, G1 oder S2, D2, G2, einem sich bis zur Grenzfläche 6 erstreckenden Ansatz KA der p-Basis 3 und einer auf der Grenzfläche 6 plazierten Metallisierungsbrücke M bestehen. Der randseitige Bereich des n-Emitterteils 2a, der mit S1 bezeichnet ist, stellt dabei ein Sourcegebiet dar. Ein Draingebiet D1, das $n^+$-dotiert ist, und ein durch eine dünne elektrisch isolierende Schicht IS1 von 6 getrenntes Gate G1 aus leitendem Material, das mit einem Anschluss G beschaltet ist, ergänzen S1 zu einem MIS-Transistor, der im leitenden Zustand eine niederohmige Verbindung von dem Ansatz KA über M zum n-Emitterteil 2a herstellt. In analoger Weise bilden die Teile S2, D2 und G2 einen zweiten MIS-Transistor, der im leitenden Zustand eine niederohmige Verbindung zwischen KA und dem Teil 2b des n-Emitters herstellt. Die Metallisierungsbrücke M verbindet dabei den Ansatz KA mit den Draingebieten D1 und D2.

Ist die Thyristoranordnung nach Fig. 1 einschliesslich der steuerbaren Emitterkurzschlüsse SK zu einer Achse 10 kreissymmetrisch ausgebildet, so liegen die MIS-Strukturen jeweils am äusseren Rand eines kreisringförmigen n-Emitterteils 2a und am inneren Rand eines kreisringförmigen n-Emitterteils 2b. In Weiterbildung dieser Ausführungsform können selbstverständlich auch mehrere solcher MIS-Strukturen eine Mehrzahl von kreisringförmigen, konzentrischen n-Emitterteilen jeweils voneinander trennen. Die n-Emitterteile 2a, 2b können aber auch streifenförmig ausgebildet sein und von streifenförmigen MIS-Strukturen flankiert sein (Fingerstruktur). Ferner kann die Anordnung nach Fig. 1 auch so ausgebildet sein, dass anstelle der voneinander getrennten n-Emitterteile 2a und 2b ein in sich geschlossener n-Emitter 2a, 2b vorgesehen ist, der mit einer Mehrzahl von möglichst gleichmässig verteilten Öffnungen OF und OF' versehen ist. In diesem Fall deuten die Bezugszeichen D1 und D2 lediglich verschiedene Schnittflächen ein und desselben kreisringförmigen $n^+$-dotierten Draingebiets an, das zu einer Achse 11 zentrisch symmetrisch ausgebildet ist. S1 und S2 bedeuten dann unterschiedliche Schnittflächen ein und derselben, die Öffnung OF umgebenden Randzone des n-Emitters 2a, 2b. Die Ansteuerung und die prinzipielle Wirkungsweise der steuerbaren Emitterkurzschlüsse SK bleiben von diesen Ausführungsvarianten unbeeinflusst. Wenn die Gatespannung, d.h. die über G zugeführte Spannung an G1 und G2, relativ zu dem darunter liegenden Teil der p-Basis 3 Null ist, sind die Feldeffekttransistoren S1, G1, D1 und S2, G2, D2 gesperrt, die Emitter-Kurzschlüsse SK sind ausgeschaltet und der Thyristor befindet sich im Zustand hoher Zündempfindlichkeit. Durch Anlegen einer positiven Gatespannung können die Kurzschlüsse SK wirksam geschaltet und der Thyristor in einen zündunempfindlichen stabilen Zustand versetzt werden. Zur Steuerung der MIS-Feldeffekttransistoren ist der Anschluss G über einen hochohmigen strombegrenzenden Widerstand R und eine Diode D3 mit dem Anodenanschluss A verbunden. Zusätzlich besteht eine Verbindung von G zum Anschluss einer weiteren $n^+$-dotierten Zone 12, die sich in enger Nachbarschaft zum inneren Rand des n-Emitters 2a befindet. Der zwischen dem inneren Rand von 2a und dem n-dotierten Bereich 12 an die Oberfläche tretende Bereich der p-Basis ist mit einer Metallisierung Z1 versehen. Der innere Rand von 2a, der unter Z1 befindliche Bereich der p-Basis 3 und die $n^+$-Zone 12 bilden Emitter, Basis und Kollektor eines npn-Lateraltransistors. Sobald nun an der Anode 9 eine positive Spannung liegt, gelangt diese auch über den Widerstand R und die Diode D3 an den Anschluss G und führt dazu, dass der Thyristor in einen zündunempfindlichen Zustand versetzt wird. Die Spannung an den Kapazitäten der Gates G1 und G2 kann dabei höchstens so gross wie die Durchbruchspannung des pn-Übergangs zwischen dem Gebiet 12 und der p-Basis 3 werden, d.h. etwa 10 bis 20 V.

Führt man dem Thyristor zum Einleiten der Zündung über die Zündelektrode Z1 und einen bei Z angeschlossenen Zündstromkreis einen positiven Zündstromimpuls Z2 zu, so bewirkt dieser eine Durchsteuerung des npn-Transistors. Hierdurch entladen sich die Kapazitäten der Gates G1 und G2, so dass die MIS-Feldeffekttransistoren sperren und der Thyristor in einen zündempfindlichen Zustand versetzt wird. Wegen der relativ grossen Gatekapazitäten der MIS-Transistoren fliesst dabei ein kräftiger, als zusätzlicher Zündstromstoss wirkender Entladestrom. Durch Parallelschalten eines externen Kondensators C zu den Gatekapazitäten kann dieser zusätzliche Zündstromstoss noch vergrössert werden.

Die Einsatzspannung der MIS-Feldeffekttransistoren sollte so klein sein, dass die nach dem Zünden an der Anode 9 anliegende Durchlassspannung ausreicht, die Emitterkurzschlüsse SK wieder wirksam zu schalten. Nur dann ist bei einem dem Abschalten des Thyristors folgenden schnellen Anstieg der an A liegenden, positiven Spannung der Thyristor vor dU/dt-Zündung geschützt.

Wird der Zündstromimpuls Z2 abgeschaltet, bevor der Thyristor voll durchgeschaltet ist, so muss verhindert werden, dass die Emitter-Kurzschlüsse SK sofort wirksam werden und zu einer Behinderung der lateralen Zündausbreitung führen. Dies kann geschehen, indem die Zeitkonstante des aus den Gatekapazitäten (und gegebenenfalls C) und dem Ladewiderstand R gebildeten RC-Gliedes grösser gewählt wird als die Ausbreitungszeit der Zündfront.

Im allgemeinen ist die im blockierenden Zustand des Thyristors an der Anode 9 anliegende Spannung wesentlich grösser als die Durchbruchspannung des npn-Transistors, was zur ungewollten Zündung des Thyristors führt. Der Widerstand R muss deshalb so gross gewählt werden, dass der über D fliessende Strom so klein bleibt, dass er weder zur Zündung des Thyristors noch zur Zerstörung der Kollektor-Basis-Diode D führt.

Nach einer Weiterbildung der Erfindung wird in einem zündunempfindlichen Randbereich des Thyristors eine zweite Diode D4 vorgesehen, die ein $n^+$-dotiertes Gebiet 14 aufweist, das mit dem Anschluss G verbunden ist. Die Durchbruchspannung von D4 wird niedriger gewählt als die der Kollektor-Basis-Diode D. Damit begrenzt D4 die Gatespannung an G1 und G2. Nach einer Schaltungsvariante kann D4 auch durch eine externe Diode ersetzt sein. Ein Ersatzschaltbild der in Fig. 1 dargestellten Anordnung ist in Abb. 2 gezeigt. Der Thyristor TH ist über einen Last-Widerstand $R_L$ mit einer Anodenspannungsquelle $U_A$

verbunden. Der MIS-Feldeffekttransistor MST beschreibt die zwischen der Kathode 7a, 7b und der p-Basis 3 des Thyristors zuschaltbaren Kurzschlüsse SK. $R_B$ bedeutet den Bahnwiderstand des Halbleiterkörpers vom inneren Rand des n-Emitterbereiches 2a bis zur ersten Kurzschlussstruktur, d.h. längs des Doppelpfeils 15, $C_G$ die Gatekapazität des MIS-Feldeffekttransistors MST, R den Ladewiderstand und D3 die Diode, über die die Kapazität $C_G$ von der Anodenspannung des Thyristors aufgeladen wird. D4 ist die integrierte oder extern zugeschaltete Diode zur Gatespannungsbegrenzung. TR beschreibt den npn-Lateraltransistor, dessen Emitter mit dem inneren Randbereich des Thyristoremitters zusammenfällt. Der Basisanschluss dieses Transistors ist mit der Zündelektrode Z1 des Thyristors und der Emitteranschluss des Transistors TR mit dem Anschluss K verbunden. Im blockierenden Zustand des Thyristors ist die Spannung zwischen K und der Zündelektrode Z1 so gering, dass weder im Transistor TR noch im Thyristor TH eine merkliche Elektroneninjektion stattfindet. Am Kollektor von TR stellt sich deshalb die Durchbruchspannung seines Kollektor-Basis-Übergangs oder die der Diode D4 ein, je nach dem welche von beiden die kleinere ist. Die Gatekapazität des MIS-Feldeffekttransistors MST ist auf diese Spannung aufgeladen, MST ist daher im leitenden Zustand. Zum Zünden des Thyristors TH wird der p-Basis 3 und der Basis des npn-Transistors TR ein Zündstromimpuls aus dem Zündstromgenerator G zugeführt. TR wird stromführend und führt zur Entladung von $C_G$ über den Anschluss K, der dem Thyristor TH und dem Transistor TR gemeinsam ist. Wenn der Entladestrom von $C_G$ gross genug ist, führt er zur Zündung des Thyristors am inneren Rand 16 des n-Emitterteils 2a.

Da der Entladestrom von $C_G$ um den Stromverstärkungsfaktor $\beta$ des npn-Transistors TR grösser ist als der Zündstromimpuls Z2, kann er auch bei kleiner Zündleistung relativ gross sein, wenn nur der Stromverstärkungsfaktor $\beta$ genügend gross ist. Man hat es also bei der Erfindung mit einer integrierten Zündstromverstärkung zu tun, wobei die Zündenergie während der Durchlass- und Blockier-Perioden von der Anodenspannungsquelle $U_A$ geliefert und bis zur Zündung in der Gatekapazität der MIS-Transistoren gespeichert wird.

In Abweichung von der bisher beschriebenen Ausführungsform kann der aus $D_3$ und R bestehende Ladestromkreis durch eine externe, gegen die Kathode K geschaltete Gleichspannungsquelle $U_E$ ersetzt sein, wie in Fig. 1 gestrichelt angedeutet ist.

Weiterhin können die Emitter-Kurzschlüsse SK sowie der genannte npn-Lateraltransistor in Abweichung von der obigen Beschreibung auch am p-Emitter 5 angeordnet sein. Zur Veranschaulichung dieser Schaltungsvariante kann die Fig. 1 herangezogen werden, wenn man die Leitungstypen der Halbleitergebiete durch die jeweils entgegengesetzten ersetzt, die Anschlüsse A und K miteinander vertauscht und die beschriebenen Spannungen und Ströme mit jeweils entgegengesetzter Polarität zuführt.

### Patentansprüche

1. Thyristor mit einem Halbleiterkörper, der einen von einer Kathode kontaktierten n-Emitter mit
einer angrenzenden p-Basis und einen von einer
Anode kontaktierten p-Emitter mit einer angrenzenden n-Basis aufweist, und mit an einer Grenzfläche des Halbleiterkörpers angeordneten, über
MIS-Transistoren steuerbaren Emitter-Kurzschlüssen, bei dem jeder MIS-Transistor einen
Randbereich des n (p)-Emitters, ein in die p (n)-
Basis eingefügtes und mit dieser leitend verbundenes n (p)-leitendes Halbleitergebiet und einen
von einem Gate überdeckten Bereich der p (n)-
Basis umfasst, dadurch gekennzeichnet, dass an
der Grenzfläche (6) ein Lateraltransistor vorgesehen ist, der einen Randbereich des n (p)-Emitters
(2a), ein weiteres, in die p (n)-Basis (3) eingefügtes, n (p)-leitendes Halbleitergebiet (12), das mit
den Gates (G1) der MIS-Transistoren verbunden
ist, und einen dazwischen liegenden Teilbereich
der p (n)-Basis (3) umfasst, dass dieser Teilbereich mit einer Zündelektrode (Z1) versehen ist
und dass die Gates (G1) der MIS-Transistoren mit
einer positiven Spannung beschaltbar sind.

2. Thyristor nach Anspruch 1, dadurch gekennzeichnet, dass die Gates (G1) der MIS-Transistoren mit einer externen Spannungsquelle (U_E) verbunden sind.

3. Thyristor nach Anspruch 1, dadurch gekennzeichnet, dass die Gates (G1) der MIS-Transistoren mit der Anode (9) verbunden sind.

4. Thyristor nach Anspruch 3, dadurch gekennzeichnet, dass die Gates (G1) der MIS-Transistoren über die Serienschaltung eines Ladewiderstandes (R) und einer Diode (D3) mit der Anode (9)
verbunden sind.

5. Thyristor nach einem der Ansprüche 1 bis 4,
dadurch gekennzeichnet, dass die Gates (G1) der
MIS-Transistoren über einen Kondensator (C) mit
der Kathode (7a, 7b) verbunden sind.

6. Thyristor nach einem der vorhergehenden
Ansprüche, dadurch gekennzeichnet, dass dem
pn-Übergang zwischen der p (n)-Basis (3) und
dem weiteren, in die p (n)-Basis (3) eingefügten,
n (p)-leitenden Halbleitergebiet (12) eine weitere,
insbesondere in die p (n)-Basis (3) integrierte
Diode (3, 14) parallelgeschaltet ist.

### Claims

1. A thyristor comprising a semiconductor body
which has an n-emitter, contacted by a cathode,
with an adjoining p-base and which has a p-emitter, contacted by an anode, with an adjacent n-
base, and having emitter short-circuits which are
arranged at a boundary surface of the semiconductor body and which can be controlled by MIS
transistors, where each MIS-transistor comprises
a boundary zone of the n(p)-emitter, a n(p)-
conducting semiconductor zone which is inserted
into the p(n)-base and is conductively connected
thereto, and a zone of the p(n)-base which is covered by a gate, characterised in that at the boundary surface (6) a lateral transistor is arranged
which comprises an edge zone of the n(p)-emitter
(2a), a further n(p)-conducting semiconductor
zone (12) which is inserted into the p(n)-base (3)
and is connected to the gates (G1) of the MIS-transistors, and an interposed sub-zone of the p(n)-
base (3); that this sub-zone is provided with an
ignition electrode (Z1); and that the gates (G1) of
the MIS-transistors can be connected to a positive
voltage.

2. A thyristor as claimed in Claim 1, characterised in that the gates (G1) of the MIS-transistors
are connected to an external voltage source (U_E).

3. A thyristor as claimed in Claim 1, characterised in that the gates (G1) of the MIS-transistors
are connected to the anode (9).

4. A thyristor as claimed in Claim 3, characterised in that the gates (G1) of the MIS-transistors
are connected to the anode (9) through the series
arrangement of a charging resistor (R) and a
diode (D3).

5. A thyristor as claimed in one of Claims 1 to
4, characterised in that the gates (G1) of the MIS-
transistors are connected to the cathode (7a, 7b)
through a capacitor (C).

6. A thyristor as claimed in one of the preceding
Claims, characterised in that the pn-junction between the p(n)-base (3) and the further n(p)-
conducting semiconductor zone (12), which is inserted into the p(n)-base (3), is connected in parallel with an additional diode (3, 14), particularly but
not exclusively one which is integrated in the p(n)-
base (3).

### Revendications

1. Thyristor avec un corps semi-conducteur,
comportant un émetteur du type n contacté avec
une cathode et à base voisine du type p, et un
émetteur du type p à base voisine du type n et
contacté avec l'anode, et avec des courts-circuits
d'émetteurs disposés au niveau d'une surface limite du corps semi-conducteur et susceptible
d'être commandés par l'intermédiaire de transistors MIS, dans lequel chaque transistor MIS comporte une zone marginale de l'émetteur n (p), une
zone de semi-conducteur inserrée dans la base p
(n) et reliée à cette dernière, et une zone de base
p (n) recouverte par une grille, caractérisé par le
fait qu'à la surface limite (6) est prévu un transistor latéral qui comporte une zone marginale de
l'émetteur (2a) du type n (p), une seconde zone
(12) du semi-conducteur du type n (p), inserrée
dans la base (3) du type p (n) et qui est reliée à la
grille (G1) des transistors MIS, et une zone partielle de la base (3) du type p (n), située entre les
précédentes, que cette zone partielle est pourvue
d'une électrode d'amorçage (Z1), et que la grille
(G1) des transistors MIS sont susceptibles d'être
portées à une tension positive.

2. Thyristor selon la revendication 1, caractérisé
par le fait que les grilles (G1) des transistors MIS sont reliées à une source de tension extérieure (U$_E$).

3. Thyristor selon la revendication 1, caractérisé par le fait que les grilles (G1) des transistors MIS sont reliées à l'anode (9).

4. Thyristor selon la revendication 3, caractérisé par le fait que les grilles (G1) des transistors MIS sont reliées à l'anode (9) par l'intermédiaire du circuit série constitué par une résistance de charge (R) et par une diode (D3).

5. Thyristor selon l'une des revendications 1 à 4, caractérisé par le fait que les grilles (G1) des transistors MIS sont reliées à la cathode (7a, 7b), par l'intermédiaire d'un condensateur (C).

6. Thyristor selon l'une des revendications précédentes, caractérisé par le fait qu'en parallèle à la jonction pn entre la base (3) du type p (n) et la seconde zone du semi-conducteur (12), du type n (p) et inserrée dans la base (3) du type p (n), est montée en parallèle une seconde diode (3, 14) en particulier intégrée dans la base (3) du type p (n).

# FIG 1

# FIG 2